# EUROPEAN PATENT APPLICATION

(11) **EP 1 968 133 A2**
(43) Date of publication of application: **10.09.2008**
(21) Application number: 08102293.1
(22) Date of filing: 05.03.2008
(51) Int. Cl.: H01L 51/52, H01L 27/32

(54) **Organic light emitting display device and method of fabricating the same**

(30) Priority: 07.03.2007 KR 20070022557
(71) Applicant: Samsung SDI Co., Ltd., Suwon-si Gyeonggi-do (KR)
(72) Inventor: Kim,, Mi-Kyung, Gyeonggi-do (KR); Chun, Min-Seung Legal IP Team Corporate Planning Staff, Suwon-si, Gyeonggi-do (KR)
(74) Representative: Hengelhaupt, Jürgen

(57) **Abstract**

An organic light emitting display device and a method of fabricating the same capable of reducing driving voltage and improving luminous efficiency. The OLED includes a substrate (200, 300); a first electrode (210, 310, 510) disposed on the substrate (200, 300); an organic layer (220, 320, 520) disposed on the first electrode (210, 310, 510) and including an organic emission layer; and a second electrode (230, 330, 530) disposed on the organic layer (220, 320, 520), and including a first metal layer (231, 331, 531) and a second metal layer (232, 332, 532).

## Description

### BACKGROUND OF THE INVENTION

### Field of the Invention

The present invention relates to an organic light emitting display device and a method of fabricating the same.

### Description of the Related Art

An organic light emitting display device includes an insulating substrate, a first electrode (anode) disposed on the insulating substrate, an organic layer including at least an emission layer (EML) disposed on the first electrode, and a second electrode (cathode) disposed on the organic layer. In the organic light emitting display device, when a voltage is applied between the first electrode and the second electrode, holes and electrons are injected into the organic layer, the holes and the electrons injected into the organic layer are re-combined with each other to generate excitons, and the excitons transition from an excited state to a ground state to thereby emit light.

A conventional bottom-emission organic light emitting display device typically uses an Al layer, as a second electrode (cathode), having appropriate reflectivity and work function. However, it is difficult to provide a high-quality organic light emitting display device using the aluminum (AI) layer because the Al layer may have improper driving voltage, current, and luminous efficiency.

### SUMMARY OF THE INVENTION

An aspect of the present invention provides an organic light emitting display device and a method of fabricating the same capable of reducing the driving voltage and increasing the luminous efficiency by forming a cathode electrode to include a metal layer having reflective characteristics, such as an aluminum (Al) layer, in addition to an magnesium and aluminum (Mg-Ag) alloy layer.

According to an embodiment of the present invention, an organic light emitting display device includes: a substrate; a first electrode disposed on the substrate; an organic layer disposed on the first electrode and including an organic emission layer; and a second electrode disposed on the organic layer, and including a first metal layer and a second metal layer.

Preferably, the first metal layer is formed of an Mg-Ag alloy. Preferably, the Mg-Ag alloy has an atomic ratio of Mg:Ag ranging from 9:1 to 1:9. Preferably, the first metal layer is formed to have a thickness ranging from about 50Å to about 500Å.

Preferably, the second metal layer is formed of a metal selected from the group consisting of Al, Ag, Ti, Mo, and Pd. Preferably, the second metal layer is formed to have a thickness ranging from about 300Å to about 3000Å.

Preferably, the first metal layer is located between the second metal layer and the organic layer.

Preferably, the second electrode is a cathode.

Preferably, the organic layer further comprises at least one layer selected from the group consisting of an electron injection layer, an electron transport layer, a hole injection layer, and a hole transport layer.

According to another embodiment of the present invention, a method of fabricating an organic light emitting display device includes: providing a substrate; forming a first electrode on the substrate; forming an organic layer including an organic emission layer on the first electrode; and sequentially forming a first metal layer and a second metal layer on the organic layer.

Preferably, the first metal layer is formed by co-depositing Mg and Ag.

Preferably, the first metal layer is formed of Mg and Ag with an atomic ratio of Mg:Ag ranging from 9:1 to 1:9.

According to another embodiment of the present invention, an organic light emitting display device includes: a substrate; a first electrode disposed on the substrate; a first organic layer disposed on the first electrode and including a first organic emission layer; a second electrode disposed on the first organic layer, and including a first metal layer and a second metal layer; a second organic layer disposed on the second electrode and including a second organic emission layer; and a third electrode disposed on the second organic layer.

### BRIEF DESCRIPTION OF THE DRAWINGS

The accompanying drawings, together with the specification, illustrate exemplary embodiments of the present invention, and, together with the description, serve to explain the principles of the present invention.

FIG. 1 is a cross-sectional schematic view of a conventional organic light emitting display device.

FIG. 2 is a cross-sectional schematic view of an organic light emitting display device in accordance with an exemplary embodiment of the present invention.

FIG. 3 is a cross-sectional schematic view of an organic light emitting display device in accordance with another exemplary embodiment of the present invention.

FIG. 4 is a graph showing the lifespan of Exemplary Embodiment 1 as compared with Comparative Example 1.

FIG. 5 is a cross-sectional schematic view of an organic light emitting display device in accordance with another exemplary embodiment of the present invention.

### DETAILED DESCRIPTION

In the following detailed description, only certain exemplary embodiments of the present invention are shown and described, by way of illustration. As those skilled in the art would recognize, the invention may be embodied in many different forms and should not be construed as being limited to the embodiments set forth herein. Also, in the context of the present application, when an element is referred to as being "on" another element, it can be directly on the another element or be indirectly on the another element with one or more intervening elements interposed therebetween. Like reference numerals designate like elements throughout the specification.

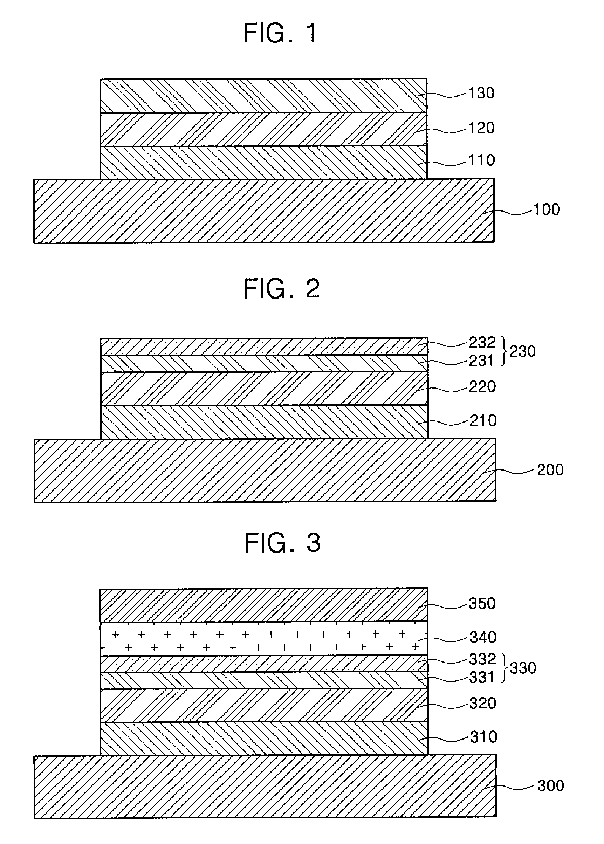

FIG. 1 is a cross-sectional schematic view of a conventional organic light emitting display device.

As shown in FIG. 1, the organic light emitting display device includes a transparent insulating substrate 100 formed of plastic, insulating glass, or the like. The transparent insulating substrate 100 may include a semiconductor layer, a gate electrode, and source and drain electrodes.

A first electrode 110 is formed on the transparent insulating substrate 100. The first electrode 110 may be formed of a material selected from the group consisting of indium tin oxide (ITO), indium zinc oxide (IZO), and zinc oxide (ZnO). Then, an organic layer 120 is formed on the first electrode 110 using a low molecule deposition method or a laser induced thermal imaging method. The organic layer 120 includes an organic emission layer, and may further include at least one thin layer selected from the group consisting of an electron injection layer, an electron transport layer, a hole injection layer, a hole transport layer, and a hole blocking layer.

An Al layer used as a second electrode metal layer is formed on a surface (or an entire surface) of the organic layer 120 to form a second electrode 130. The Al layer is a thin metal layer that can reflect light emitted from the organic layer 120 as a function of its thickness.

In view of the foregoing, a bottom-emission organic light emitting display device typically uses an Al layer, as a second electrode, having appropriate reflectivity and work function. However, it is difficult to provide a high-quality organic light emitting display device using the Al layer because the Al layer may have improper driving voltage, current, and luminous efficiency.

FIG. 2 is a cross-sectional schematic view of an organic light emitting display device in accordance with an exemplary embodiment of the present invention. In one embodiment, the organic light emitting display device is (or includes) an organic light emitting diode (OLED).

Referring to FIG. 2, the organic light emitting display device includes a substrate 200. The substrate 200 may be formed of an insulating glass, plastic, and/or conductive substrate. Here, the organic light emitting display device may further include a thin film transistor disposed on the substrate 200 (the thin film transistor including a semiconductor layer, a gate electrode, and source and drain electrodes) and/or a capacitor disposed on the substrate 200.

In addition, a first electrode material is deposited on a surface (or an entire surface) of the substrate 200 and then patterned to form a first electrode 210. Here, the first electrode 210 may be formed of indium tin oxide (ITO) and/or indium zinc oxide (IZO) having a high work function. In one embodiment, ITO is used to form the first electrode 210.

An organic layer 220 is formed on the first electrode 210 (or on the substrate 200). The organic layer 220 includes at least an emission layer, and may further include at least one layer selected from the group consisting of a hole injection layer, a hole transport layer, an electron transport layer, and an electron injection layer. In addition, the organic layer 220 may be formed by a low molecule deposition method and/or a laser induced thermal imaging method.

A second electrode 230 is formed on a surface (or an entire surface) of the organic layer 220 (or on the substrate 200). The second electrode 230 may be composed of a first metal layer 231 and a second metal layer 232. Here, the first metal layer 231 may be formed of an Mg-Ag alloy with an atomic ratio of Mg:Ag ranging from 9:1 to 1:9; and, in one embodiment, from 8:1 to 1:8. The first metal layer 231 may have a thickness ranging from 50 to 500Å. In one embodiment, considering electron injection characteristics of the first metal layer 231, the first metal layer 231 has a thickness of more than 50Å. In another embodiment, considering luminous efficiency such as driving voltage and so on, the first metal layer 231 has a thickness of less than 500Å.

Also, in the case of a bottom-emission structure, the second metal layer 232 may be formed of a metal selected from the group consisting of Al, Ag, Ti, Mo, and Pd, which have good reflectivity characteristics (or reflective characteristics). In one embodiment, Al is used, which has a relatively high reflectivity. Here, the second metal layer 232 may have a thickness ranging from 300 to 3000Å. In one embodiment, considering a reflective layer function (or characteristic), the second metal layer 232 has a thickness of more than 300Å. In another embodiment, considering process time and manufacturing efficiency, the second metal layer 232 has a thickness of less than 3000Å.

In addition, in the case of a dual-emission structure, the second metal layer 232 may be formed of a metal selected from the group consisting of Al, Ag, Ti, Mo, and Pd, to have transmissive characteristics. Here, the second metal layer 232 may have a thickness that is relatively thin such that light can pass through the metal. For instance, if the second metal layer 232 has a thickness below 300Å, light can be transmitted.

In a manufacturing process embodiment, the first metal layer 231 may be formed by a co-deposition method of simultaneously (or concurrently) depositing Mg and Ag metals (or co-depositing Mg and Ag). In addition, the second metal layer 232 may be formed on the deposited first metal layer 231 using any suitable deposition method.

Here, in FIG. 2, the first electrode 210 acts as an anode, and the second electrode 230 acts as a cathode. In another (or alternative) embodiment, the second electrode 230 acting as a cathode is disposed between the organic layer 220 and the substrate 200, and the first electrode 210 acting as an anode is disposed on the organic layer 220, thereby forming an inverted structure.

As a result, the organic light emitting display device in accordance with FIG. 2 is completed.

An organic light emitting display device in accordance with another exemplary embodiment of the present invention will be described with reference to FIG. 3.

FIG. 3 is a cross-sectional schematic view of the organic light emitting display device in accordance with the another exemplary embodiment of the present invention.

Referring to FIG. 3, the organic light emitting display device includes a substrate 300 formed of plastic, insulating glass, or the like. Here, the organic light emitting display device may further include a thin film transistor disposed on the substrate 300 (the thin film transistor including a semiconductor layer, a gate electrode, and source and drain electrodes) and/or a capacitor disposed on the substrate 300.

In addition, a first electrode material is deposited on a surface (or an entire surface) of the substrate 300 and then patterned to form a first electrode 310. Here, the first electrode 310 may be formed of indium tin oxide (ITO) and/or indium zinc oxide (IZO) having a high work function. In one embodiment, ITO is used to form the first electrode 310. In addition, the first electrode 310 in an active matrix structure may be electrically connected to the thin film transistor disposed thereunder.

A first organic layer 320 is formed on the first electrode 310 (or on the substrate 300). The organic layer 320 includes at least an emission layer, and may further include at least one layer selected from the group consisting of a hole injection layer, a hole transport layer, an electron transport layer, and an electron injection layer.

A second electrode 330 is formed on a surface (or an entire surface) of the first organic layer 320 (or on the substrate 300). The second electrode 330 may be composed of a first metal layer 331 and a second metal layer 332. Here, the first metal layer 331 may be formed of an Mg-Ag alloy with an atomic ratio of Mg:Ag ranging from 9:1 to 1:9; and, in one embodiment, from 8:1 to 1:8. The first metal layer 331 may have a thickness ranging from 50 to 500Å. In one embodiment, considering electron injection characteristics of the first metal layer 331, the first metal layer 331 has a thickness of more than 50Å. In another embodiment, considering luminous efficiency such as driving voltage and so on, the first metal layer 331 has a thickness of less than 500Å.

Also, the second metal layer 332 may be formed of a metal selected from the group consisting of Al, Ag, Ti, Mo, and Pd, which have good reflectivity characteristics. In one embodiment, Al is used, which has a relatively high reflectivity. Here, the second metal layer 332 may have a thickness ranging from 300 to 3000Å. In one embodiment, considering a reflective layer function (or characteristic), the second metal layer 332 has a thickness of more than 300Å. In another embodiment, considering process time and manufacturing efficiency, the second metal layer 332 has a thickness of less than 3000Å.

In a manufacturing process embodiment, the first metal layer 331 may be formed by a co-deposition method of simultaneously (or concurrently) depositing Mg and Ag metals. In addition, the second metal layer 332 may be formed on the deposited first metal layer 331 using any suitable deposition method.

Here, in FIG. 3, a second organic layer 340 is formed on the second electrode 330. The second organic layer 340 includes at least an emission layer, and may further include at least one layer selected from the group consisting of a hole injection layer, a hole transport layer, an electron transport layer, and an electron injection layer (and may be substantially the same as the first organic layer 320).

In FIG. 3, a third electrode 350 is also formed on a surface (or an entire surface) of the second organic layer 340 (or on the substrate 300). The third electrode 350 acting as a transmissive electrode may be formed of a material selected from the group consisting of ITO, IZO, ZnO, and combinations thereof.

In the case of a passive matrix structure, the third electrode 350 may be electrically connected to the first electrode 310 to be driven together with the first electrode 310, and in the case of an active matrix structure, the third electrode 350 may be connected to a thin film transistor connected to the first electrode 310 to be driven together with the first electrode 310.

In operation, holes are supplied from the first electrode 310, and electrons are supplied from the second electrode 330 to emit light from the organic layer of the first organic layer 320. Here, the second metal layer 332 of the second electrode 330 acts as a reflective layer to emit the light downward (or toward the substrate 300). Also (or at substantially the same time), electrons are supplied from the second electrode 330, and holes are supplied from the third electrode 350 to emit light from the organic emission layer of the second organic layer 340. The second metal layer 332 of the second electrode 330 disposed under the second organic layer 340 acts as a reflective layer to emit the light upward (or toward the third electrode 350). Therefore, a dual emission display for emitting light upward and downward can be implemented.

As a result, a dual-emission organic light emitting display device in accordance with FIG. 3 is completed.

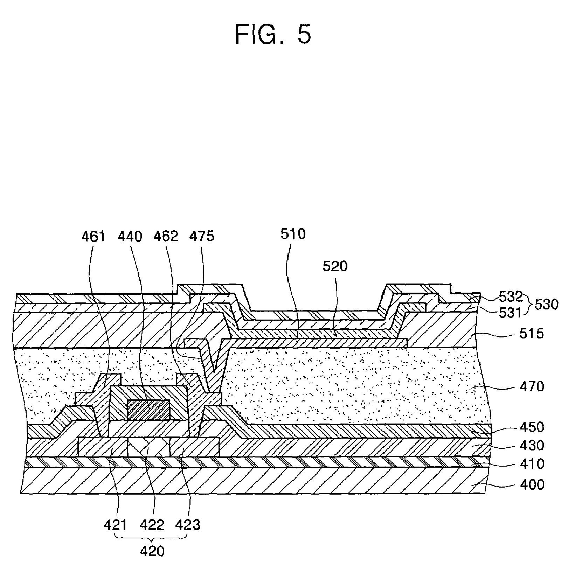

FIG. 5 is a cross-sectional schematic view of an organic light emitting display device in accordance with another exemplary embodiment of the present invention.

Referring to FIG. 5, the organic light emitting display device includes a substrate 400. The substrate 400 may be formed of an insulating glass, plastic, and/or conductive substrate.

In addition, a buffer layer 410 is disposed on the substrate 400. A semiconductor layer 420 is disposed on the buffer layer 410. The semiconductor layer 420 can include source and drain sections 421, 423 formed at two opposite sides of the semiconductor layer 420 and a channel section 422 formed between the source and drain sections 421, 423. In one embodiment, the semiconductor layer 420 may be part of a thin film transistor. The thin film transistor can be any suitable transistor selected from an amorphous silicone thin film transistor, a poly-silicone thin film transistor, an organic thin film transistor, a micro silicone thin film transistor and their equivalents, but not limited thereto. In one embodiment, the thin film transistor may be any MOS selected from a PMOS, an NMOS and their equivalents, but not limited thereto.

A gate insulating layer 430 is disposed on the semiconductor layer 420. In one embodiment, the gate insulating layer 430 can also be formed on the buffer layer 410 at the outer circumference of the semiconductor layer 420.

A gate electrode 440 is disposed on the gate insulating layer 430. More specifically, the gate electrode 440 can be formed on the gate insulating layer 430 to correspond to the channel section 422 of the semiconductor layer 420. The gate electrode 440 enables a hole or electron channel to be formed in the channel section 422 by applying an electric field to the channel section 422.

An inter-layer dielectric layer 450 is disposed on the gate electrode 440. In one embodiment, the inter-layer dielectric layer 450 can also be formed on the gate insulating layer 430 at the outer circumference of the gate electrode 440.

Source and drain electrodes 461, 462 are disposed on the inter-layer dielectric layer 450. In one embodiment, each of the source and drain electrodes includes an electrically conductive contact configured to penetrate through the inter-layer dielectric layer 450 to contact the semiconductor layer 420. That is, the semiconductor layer 420 is electrically coupled with the source and drain electrodes 461, 462 via (or by) the electrically conductive contacts.

An insulating layer 470 is disposed on the source and drain electrodes 461, 462. The insulating layer 470 can include a protective layer and a planarization layer.

In addition, a first electrode material is deposited on the insulating layer 470 and then patterned to form a first electrode 510. Here, the first electrode 510 may be formed of indium tin oxide (ITO) and/or indium zinc oxide (IZO) having a high work function. In one embodiment, ITO is used to form the first electrode 510.

An organic layer 520 is disposed on the first electrode 510. The organic layer 520 includes at least an emission layer, and may further include at least one layer selected from the group consisting of a hole injection layer, a hole transport layer, an electron transport layer, and an electron injection layer.

A second electrode 530 is disposed on the organic layer 520. The second electrode 530 may be composed of a first metal layer 531 and a second metal layer 532. Here, the first metal layer 531 may be formed of an Mg-Ag alloy with an atomic ratio of Mg:Ag of 9:1 to 1:9; and, in one embodiment, from 8:1 to 1:8. The first metal layer 531 may have a thickness ranging from 50 to 500Å. In one embodiment, considering electron injection characteristics of the first metal layer 531, the first metal layer 531 has a thickness of more than 50Å. In another embodiment, considering luminous efficiency such as driving voltage and so on, the first metal layer 531 has a thickness of less than 500Å.

Also, in the case of a bottom-emission structure, the second metal layer 532 may be formed of a metal selected from the group consisting of Al, Ag, Ti, Mo, and Pd, which have good reflectivity characteristics (or reflective characteristics). In one embodiment, Al is used, which has a relatively high reflectivity. Here, the second metal layer 532 may have a thickness ranging from 300 to 3000Å. In one embodiment, considering a reflective layer function (or characteristic), the second metal layer 532 has a thickness of more than 300Å. In another embodiment, considering process time and manufacturing efficiency, the second metal layer 532 has a thickness of less than 3000Å.

In addition, in the case of a dual-emission structure, the second metal layer 532 may be formed of a metal selected from the group consisting of Al, Ag, Ti, Mo, and Pd, to have transmissive characteristics. Here, the second metal layer 532 may have a thickness that is relatively thin such that light can pass through the metal.

In a manufacturing process embodiment, the first metal layer 531 may be formed by a co-deposition method of simultaneously (or concurrently) depositing Mg and Ag metals (or co-depositing Mg and Ag). In addition, the second metal layer 532 may be formed on the deposited first metal layer 531 using any suitable deposition method.

Here, in FIG. 5, the first electrode 510 acts as an anode, and the second electrode 530 acts as a cathode. In another (or alternative) embodiment, the second electrode 530 acting as a cathode is disposed between the organic layer 520 and the substrate 400, and the first electrode 510 acting as an anode is disposed on the organic layer 520, thereby forming an inverted structure.

Moreover, the first electrode 510 and at least one of the source and drain electrodes 461, 462 can be electrically coupled by an electrically conductive via 475 penetrating through the insulating layer 470.

In addition, a pixel defining layer 515 can be disposed on the insulating layer 470 at the outer circumference of the first electrode 510, the organic layer 520 and/or the second electrode 530 to define boundaries between a red organic light emitting diode, a green organic light emitting diode and a blue organic light emitting diode, and thus defines light emitting boundary regions between pixels.

Here, a second organic layer (e.g., the second organic layer 340 of FIG. 3) may be disposed on the second electrode 530. Also, a third electrode (e.g., the third electrode 350 of FIG. 3) may be disposed on the second organic layer. The third electrode acting as a transmissive electrode may be formed of a material selected from the group consisting of ITO, IZO, ZnO, and combinations thereof.

In the case of a passive matrix structure, the third electrode may be electrically connected to the first electrode 510 to be driven together with the first electrode 510, and in the case of an active matrix structure, the third electrode may be connected to a thin film transistor (e.g., including the semiconductor layer 420, the gate electrode 440, and source and drain electrodes 461, 462) connected to the first electrode 510 to be driven together with the first electrode 510.

The following exemplary embodiments illustrate the present invention in more detail. However, the present invention is not limited by these exemplary embodiments.

### Exemplary Embodiment 1

A first electrode formed of indium tin oxide (ITO) was deposited on a substrate to have a thickness of 130nm, a hole injection layer formed of 4,4',4"-tris(N-3-methylphenyl-N-phenyl1-amino)-triphenylamine (m-MTDATA) was deposited on the first electrode to have a thickness of 130nm, and a hole transport layer formed of n-propyl bromide (NPB) was deposited to have a thickness of 20nm. A blue emission layer was deposited on the hole transport layer to have a thickness of 20nm by mixing 4,4'-bis(2,2'-diphenyl vinyl)-1,1'-biphenyl) (DPVBi) as a host with 2wt% perylene as a dopant, and an electron transport layer formed of 2-(4-biphenylyl)-5-(4-tert-butyl)-1,3,4-oxadiazole (PBD) was deposited to have a thickness of 30nm. Then, an electrode (e.g., the second electrode 230 or 330) formed of an Mg-Ag layer was deposited to have a thickness of 160Å, and an Al layer was deposited on the Mg-Ag layer to have a thickness of 1000Å.

### Comparative Example 1

Comparative Example 1 is similar to Exemplary Embodiment 1, except that an electrode (e.g., the electrode 130) formed of an Al layer only (instead of the Mg-Ag layer and Al layer) was deposited to have a thickness of 1000Å.

### Exemplary Embodiment 2

Exemplary Embodiment 2 is substantially the same as Exemplary Embodiment 1, except that a green emission layer was formed by mixing 8-trishydroxyquinoline aluminum (Alq3) as a host with 3wt% DPT available from Mitsubishi as a dopant, instead of the blue emission layer formed by mixing 4,4'-bis(2,2'-diphenyl vinyl)-1,1'-biphenyl) (DPVBi) as a host with 2wt% perylene as a dopant.

### Comparative Example 2

Comparative Example 2 is substantially the same as Exemplary Embodiment 2, except that an electrode (e.g., the electrode 130) formed of an Al layer only instead of the Mg-Ag layer/Al layer was deposited to have a thickness of 1000Å.

### Exemplary Embodiment 3

Exemplary Embodiment 3 is substantially the same as Exemplary Embodiment 1, except that a red emission layer was formed to have a thickness of 40nm by mixing 4,4'-biscarbazolylbiphenyl (CBP) as a host with 15wt% PQlr (acac) as a dopant, instead of the blue emission layer formed by mixing 4,4'-bis(2,2'-diphenyl vinyl)-1,1'-biphenyl) (DPVBi) as a host with 2wt% perylene as a dopant.

### Comparative Example 3

Comparative Example 3 is substantially the same as Exemplary Embodiment 3, except that an electrode (e.g., the electrode 130) formed of an Al layer only instead of the Mg-Ag layer/Al layer was deposited to have a thickness of 1000Å.

Measurement results of driving voltages, current consumption and luminous efficiency of organic light emitting display devices fabricated by Exemplary Embodiments 1, 2 and 3 and Comparative Examples 1, 2 and 3 are shown in Table 1.

**Table 1**

| | Driving voltage (V) | Current Consumption (mA/cm²) | Luminous Efficiency (Cd/A) |
|---|---|---|---|
| Comparative Example 1 | 6.150 | 14.565 | 5.480 |
| Exemplary Embodiment 1 | 4.655 | 11.893 | 6.668 |
| Comparative Example 2 | 5.449 | 10.042 | 14.917 |
| Exemplary Embodiment 2 | 4.549 | 9.543 | 15.636 |
| Comparative Example 3 | 4.748 | 14.235 | 5.660 |
| Exemplary Embodiment 3 | 4.153 | 13.656 | 5.924 |

As shown in Table 1 and by comparing Exemplary Embodiment 1 with Comparative Example 1, Exemplary Embodiment 2 with Comparative Example 2, and Exemplary Embodiment 3 with Comparative Example 3, it can be appreciated that a deposition structure of an Mg-Ag layer and an Al layer yields to reduced driving voltage and current consumption, and to an increased luminous efficiency in all of the red, green and blue emission layers as compared with an conventional electrode (e.g., the electrode 130) formed of an Al layer only.

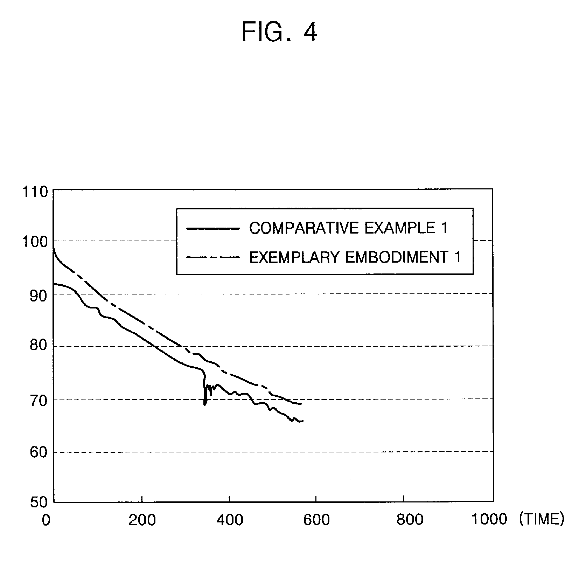

In addition, FIG. 4 is a graph showing the lifespan of the Exemplary Embodiment 1 as compared with the Comparative Example 1.

Referring to FIG. 4, an X-axis represents test hours of lifespan, and a Y-axis represents a relative brightness value of Comparative Example 1 in a state that the brightness of Exemplary Embodiment 1 is set to 100. As shown in FIG. 4, it can be appreciated that Exemplary Embodiment 1 having an electrode (e.g., the electrode 230 or 330) formed of an Mg-Ag layer and an Al layer shows higher brightness and longer lifespan in comparison with Comparative Example 1 having an electrode (e.g., the electrode 130) formed of an Al layer only.

As described above, in the second electrode 330, the first metal layer 331 formed of an Mg-Ag layer improves electron injection characteristics and the second metal layer 332 formed of an Al layer acts as a reflective layer or a transmissive layer so that driving voltage, current consumption, lifespan and luminous efficiency may be improved in comparison with the conventional organic light emitting display device.

As can be seen from the foregoing, it is possible to decrease driving voltage and current consumption, and to increase lifespan and/or luminous efficiency in each of red, green, and blue emission layers and thus implement a high-quality organic light emitting display device by employing a second electrode to include a metal layer having reflective characteristics such as an Mg-Ag layer and an Al layer.

While the invention has been described in connection with certain exemplary embodiments, it will be appreciated by those skilled in the art that the invention is not limited to the disclosed embodiments, but, on the contrary, is intended to cover various modifications included within the scope of the invention, which is defined in the claims and their equivalents.

## Claims

1. An organic light emitting display device comprising:
a substrate (200, 300, 400);
a first electrode (210, 310, 510) disposed on the substrate (200, 300, 400);
an organic layer (220, 320, 520) disposed on the first electrode (210, 310, 510), and including an organic emission layer; and
a second electrode (230, 330, 530) disposed on the organic layer (220, 320, 520), and including a first metal layer (231, 331, 531) and a second metal layer (232, 332, 532).

2. The organic light emitting display device according to claim 1, wherein the first metal layer (231, 331, 531) is formed of an Mg-Ag alloy.

3. The organic light emitting display device according to claim 2, wherein the Mg-Ag alloy has an atomic ratio of Mg:Ag ranging from 9:1 to 1:9.

4. The organic light emitting display device according to one of the preceding claims, wherein the second metal layer (232, 332, 532) is formed of a metal selected from the group consisting of Al, Ag, Ti, Mo, and Pd.

5. The organic light emitting display device according to one of the preceding claims, wherein the first metal layer (231, 331, 531) is formed to have a thickness ranging from about 50Å to about 500Å.

6. The organic light emitting display device according to one of the preceding claims, wherein the second metal layer (232, 332, 532) is formed to have a thickness ranging from about 300Å to about 3000Å.

7. The organic light emitting display device according to one of the preceding claims, wherein the first metal layer (231, 331, 531) is located between the second metal layer (232, 332, 532) and the organic layer (220, 320, 520).

8. The organic light emitting display device according to one of the preceding claims, wherein the second electrode (230, 330, 530) is a cathode.

9. The organic light emitting display device according to one of the preceding claims, wherein the organic layer (220, 320, 520) further comprises at least one layer selected from the group consisting of an electron injection layer, an electron transport layer, a hole injection layer, and a hole transport layer.

10. An organic light emitting display device according to one of claims 1 through 9, further comprising:
a second organic layer (340) disposed on the second electrode (330), and
including a second organic emission layer; and
a third electrode (350) disposed on the second organic layer (340).

11. The organic light emitting display device according to claim 10, wherein the third electrode (350) is formed of a material selected from the group consisting of ITO, IZO and ZnO.

12. The organic light emitting display device according to one of the preceding claims, further comprising a thin film transistor electrically connected to the first electrode (510).

13. The organic light emitting display device according to one of claims 10 and 11, wherein the first electrode (310) is electrically connected to the third electrode (350).

14. The organic light emitting display device according to one of claims 10 and 11, further comprising a thin film transistor electrically connected to the first electrode (310) and the third electrode (350) to drive both the first electrode (310) and the third electrode (350).

15. A method of fabricating an organic light emitting display device, the method comprising:
providing a substrate (200, 300, 400);
forming a first electrode (210, 310, 510) on the substrate (200, 300, 400);
forming an organic layer (220, 320, 520) including an organic emission layer on the first electrode (210, 310, 510);
sequentially forming a first metal layer (231, 331, 531) and a second metal layer (232, 332, 532) on the organic layer (220, 320, 520).

16. The method according to claim 15, wherein the first metal layer (231, 331, 531) is formed by co-depositing Mg and Ag.

17. The method according to one of claims 15 and 16, wherein the first metal layer (231, 331, 531) is formed of Mg and Ag with an atomic ratio of Mg:Ag ranging from 9:1 to 1:9.
